(19) Europäisches Patentamt
European Patent Office
Office européen des brevets

(11) EP 2 251 371 B1

(12) # EUROPÄISCHE PATENTSCHRIFT

(45) Veröffentlichungstag und Bekanntmachung des Hinweises auf die Patenterteilung:
**19.04.2017 Patentblatt 2017/16**

(21) Anmeldenummer: **10004770.3**

(22) Anmeldetag: **06.05.2010**

(51) Int Cl.:
*C08K 5/098* (2006.01) *C08K 5/16* (2006.01)
*B29K 67/00* (2006.01) *B32B 27/08* (2006.01)
*C08J 5/18* (2006.01) *B32B 27/36* (2006.01)
*H01L 31/048* (2014.01) *H01B 3/42* (2006.01)
*B29D 7/01* (2006.01) *B32B 27/18* (2006.01)
*B32B 27/20* (2006.01) *B29C 55/00* (2006.01)
*C08K 3/16* (2006.01) *C08L 67/00* (2006.01)
*C08L 67/02* (2006.01) *C08K 3/32* (2006.01)
*C08K 5/00* (2006.01) *C08L 67/03* (2006.01)
*C08K 13/02* (2006.01)

(54) **Biaxial gestreckte Polyesterfolie, enthaltend einen Decarboxylierungskatalysator, Verfahren zu ihrer Herstellung und ihre Verwendung in Elektroisolieranwendungen**

Biaxially stretched polyester film containing a decarboxylation catalyst and method for production of same and use of same in electrical insulation applications

Feuille de polyester étirée biaxialement comprenant un catalyseur de décarboxylation, son procédé de fabrication et utilisation dans des applications d'isolation électrique

(84) Benannte Vertragsstaaten:
**BE DE ES FR GB IT LU PL TR**

(30) Priorität: **15.05.2009 DE 102009021566**

(43) Veröffentlichungstag der Anmeldung:
**17.11.2010 Patentblatt 2010/46**

(73) Patentinhaber:
- **Mitsubishi Polyester Film GmbH
65203 Wiesbaden (DE)**
- **Advansa Sasa Polyester Sanayi A.S.
01355, Seyhan, Adana (TR)**

(72) Erfinder:
- **Kliesch, Holger, Dr.
65462 Ginsheim (DE)**
- **Kuhmann, Bodo
65594 Runkel (DE)**
- **Klein, Dagmar, Dr.
55427 Ockenheim (DE)**
- **Bursch, Annegrete
65385 Rüdesheim (DE)**
- **Kurz, Rainer
65307 Bad Schwalbach (DE)**
- **Bröder, Dirk, Dr.
55444 Schweppenhausen (DE)**
- **Turan, Ahmet Celalettin
34325 Avcilar Istanbul (TK)**
- **Kacukaltun, Engin
Yüregir
Adana (TR)**
- **Kolbasi, Murat
Adana (TR)**

(74) Vertreter: **Schweitzer, Klaus et al
Plate Schweitzer Zounek
Patentanwälte
Rheingaustrasse 196
65203 Wiesbaden (DE)**

(56) Entgegenhaltungen:
**EP-A1- 1 842 662 DE-A1- 10 209 847
US-A- 3 446 766 US-A- 3 952 125
US-B2- 6 984 694**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 251 371 B1

## Beschreibung

Die Erfindung betrifft eine biaxial gestreckte Folie aus einem Polyester, deren Dicke bevorzugt im Bereich von 6 bis 500 μm liegt. Die Folie enthält mindestens einen Decarboxylierungskatalysator und zeichnet sich durch ihre gute Herstellbarkeit, eine sehr gute Hydrolysebeständigkeit und gute Elektroisoliereigenschaften aus. Die Erfindung betrifft ferner ein Verfahren zur Herstellung der Folie sowie ihre Verwendung.

Biaxial gestreckte Folien aus Polyestern im angegebenen Dickenbereich sind hinreichend bekannt.

In Elektroisolieranwendungen wie Kabeln, Motorisolierung oder Folien für Rückseitenlaminate von Solarmodulen werden in der Regel relativ lange Lebensdauern von mehreren Jahren zum Teil unter Anwendungstemperaturen gefordert, die in die Region der Glastemperatur von Polyester (Polyethylenterephthalat) von ca. 78 °C kommen. Unter diesen Bedingungen wird die Hydrolyseneigung der Polyester eine kritische Größe für die Lebensdauer in der Anwendung. Bereits früh konnte gezeigt werden (McMahon et al., Journal of Chemical Engineering Data, Vol. 4 (1), Seiten 57 bis 78, Januar 1959), dass hierfür eine bestimmte Viskosität (Maß für die Kettenlänge des Polymers) nicht unterschritten werden darf (0,3 bis 0,33 IV ist kritisch). Der positive Einfluss eines niedrigen Carboxylendgruppengehaltes (CEG content) auf die Hydrolysegeschwindigkeit ist ebenfalls schon sehr lange bekannt (z. B. US-A-3,051,212 von 1962). Die in der industriellen Praxis angewandten Verfahren zur Herstellung von Polyestern mit niedrigem Carboxylendgruppengehalt umfassen eine akribische Prozesskontrolle und anschließende Festphasenpolymerisation. Solche Rohstoffe finden insbesondere in der Herstellung von Hochleistungsfasern Verwendung.

Der Nachteil solcher Rohstoffe für die Anwendung in Polyesterfolien liegt in der für Folien ökonomischen Notwendigkeit der Verwendung des Eigenregenerates. Bei der Herstellung von biaxial gestreckten Polyesterfolien werden prozessbedingt im Regelfall 1,5 bis 2,5 kg Rohstoff für ein kg Folie benötigt. Der Rest fällt in Form von Randstreifen und Folienverschnitt an, der gehäckselt wird und anschließend direkt wieder eingesetzt oder zunächst extrudiert und regaranuliert und dann wieder eingesetzt wird. Bei der Folienherstellung und erst recht bei der nachgeschalteten erneuten Extrusion zur Regeneratherstellung (Regranulat) steigt der Carboxylendgruppengehalt und damit die Hydrolyseneigung aber stark an und beschränkt so den Wiedereinsatz von Regenerat bis hin zur Notwendigkeit des Verzichtes auf diesen.

Ein weiteres Problem ist die Schwierigkeit, auf dem Wege der Nachkondensation Carboxylendgruppengehalte unterhalb von 15 meq/kg zu erreichen. Diese sind jedoch erstrebenswert, um deutlich reduzierte Hydrolysegeschwindigkeiten zu erreichen, wie sie in den oben genannten Endanwendungen benötigt werden. Wenn dies auf dem Weg der Nachkondensation erreicht werden soll, sind sehr lange Kondensationszeiten notwendig (wirtschaftlich ungünstig), und es müssen sehr hohe Viskositäten > 0,8 oder sogar > 0,85 IV angestrebt werden. Je höher die Viskosität ist, desto schwieriger ist aber die Verarbeitung solcher Rohstoffe auf konventionellen Polyesterfolienanlagen, da hohe Stromaufnahmen in den Extrudern die Folge sind und zudem die hohe Viskosität zu einer sehr hohen Scherwärme führt, die die initial guten Hydrolyseeigenschaften durch Neubildung von Carboxylendgruppen in der Extrusion wieder zunichte macht.

Neben der oben beschriebenen Methode der Herstellung von Polyestern mit niedrigem Carboxylendgruppengehalt über Prozessoptimierung und dem zusätzlichen Prozessschritt der Nachkondensation (Festphasenkondensation o. Festphasenpolymerisation) sind viele Verfahren zum Endcapping mit reaktiven Agentien beschrieben worden. Häufig werden Ethylencarbonat (z. B. DE-A-19526405) oder auch polymere Reaktionspartner wie Carbodiimide (US-A-2002/065346) genannt. Nachteile dieser Zuschlagstoffe sind das Ausgasen von reizenden Nebenprodukten (insbesondere bei Carbodiimiden) oder das Ablagern von Abbauprodukten oder vom Endcapping Agens selbst an der Düse oder im Fixierrahmen. Zudem sind die Endcapping Agentien, wenn sie einmal abreagiert sind, unwirksam und die Bildung der Carboxylendgruppen im Polymer beginnt erneut, was zu dem oben erwähnten Regeneratproblem führt. Polymere und andere mehrfunktionelle Endcapping-Agentien wie Carbodiimide oder Glycidylgruppen enthaltende Polymere wie in EP-A-1 499 668 beschrieben wirken nicht nur endgruppenreduzierend, sondern auch kettenverlängernd oder gar vernetzend, was zu einem schwer kontrollierbaren Viskositätsanstieg während der Extrusion führen kann.

Zudem werden durch solche Zusatzstoffe in den Polyester Fremdmaterialien eingebracht, die die initial sehr guten Elektroisoliereigenschaften von Polyester beeinträchtigen können.

Ganz generell führen Zuschlagstoffe wie die oben genannten zur Erhöhung der Kosten (Kosten des Stoffes selbst und die Kosten der Einbringung in den Polyester) und sind prozessseitig schwer beherrschbar.

US-A-3,446,766 beschreibt eine Methode zur Verringerung der Endgruppen, die auf einer Decarboxilierungsreaktion beruht und nicht auf einem reaktiven Endcapping mit einer im Produkt verbleibenden Endgruppe. Es werden Rohstoffherstellung und daraus hergestellte Fasern beschrieben, nicht aber die Herstellung biaxial gestreckter Folien und deren Verwendung in Elektroisolieranwendungen.

Ziel der vorliegenden Erfindung war es, eine Polyesterfolie der Dicke 6 bis 500 μm bereitzustellen, die die genannten Nachteile des Standes der Technik vermeidet, sich kostengünstig herstellen lässt, sich durch gute Elektroisoliereigenschaften auszeichnet und sich so zur Verwendung in Elektroisolieranwendungen eignet, wozu insbesondere die Eignung für Rückseitenlaminate von Solarmodulen zählt.

Erreicht wird dies durch eine biaxial gestreckte Folie, die überwiegend aus einem Polyester besteht, der mindestens ein Kupfersalz und ein Halogenid enthält, wobei das Mol-Verhältnis Halogenid zu Cu 0,5 bis 3,5 beträgt. Die

Folie weist eine Spannungsfestigkeit (Durchschlagfestigkeit) AC (Alternating Current) bei 23 °C und 50 Hz von mindestens 100 kV/mm, bevorzugt von mindestens 200 kV/mm auf.

Die Folie enthält als Hauptbestandteil einen Polyester. Geeignete Polyester sind beispielsweise Polyethylenterephthalat (PET), Polyethylennaphthalat (PEN), Polybutylenterephthalat (PBT), Polytrimethylenterephthalat (PTT), bibenzolmodifiziertes Polyethylenterephthalat (PETBB), bibenzolmodifiziertes Polybutylenterephthalat (PBTBB), bibenzolmodifiziertes Polyethylennaphthalat (PENBB) oder Mischungen daraus, wobei PET, PBT, PEN und PTT sowie deren Mischungen und Co-Polyester bevorzugt sind. Die polymeren Bestandteile der Folie bestehen bevorzugt zu 90 Gew.-% und besonders bevorzugt zu 95 Gew.-% aus einem Polyester. Diese Gewichtsprozentangaben beziehen sich - wie auch im Folgenden - auf die Folie, sofern nichts anderes gesagt ist.

Zur Herstellung der Polyester können neben den Hauptmonomeren wie Dimethylterephthalat (DMT), Ethylenglycol (EG), Propylenglycol (PG), 1,4-Butandiol, Terephthalsäure (TA), Benzoldicarbonsäure und/oder 2,6-Naphthalindicarbonsäure (NDA) auch Isophthalsäure (IPA), trans- und/oder cis-1,4-Cyclohexandimethanol (c-CHDM, t-CHDM oder c/t-CHDM), Neopentylglykol und andere geeignete Dicarbonsäurekomponenten (oder Dicarbonsäureester) und Diolkomponenten verwendet werden.

Bevorzugt sind Polymere, bei denen die Dicarbonsäurekomponente zu 90 Gew.-%. (bezogen auf die Gesamtmenge der Dicarbonsäurekomponente) und mehr, insbesondere zu 98 Gew.-% und mehr, aus TA oder NDA besteht, wobei TA besonders bevorzugt ist. Bevorzugt sind weiterhin Thermoplaste, bei denen die Diolkomponente zu 93 Gew.-% und mehr, besser zu 95 Gew.-% und mehr und insbesondere zu 97 Gew.-% (bezogen auf die Gesamtmenge der Diole) und mehr, aus EG besteht. Im Vorstehenden wie Nachfolgenden ist unter der/dem jeweils angegebenen Dicarbonsäurekomponente oder -anteil bzw. Diolkomponente oder -anteil die jeweilige in das Polymer eingebaute Wiederholungseinheit zu verstehen.

Tendenziell verringern alle Diolkomponenten, die von EG abweichen, die Hydrolysebeständigkeit und die Durchschlagfestigkeit. Die Folie weist deshalb bevorzugt einen Diethylenglycolanteil am Gesamtpolymer im Bereich von 0,25 bis 3 Gew.-% auf, und besonders bevorzugt ist ein Diethylenglycolanteil am Gesamtpolymer im Bereich von 0,4 bis 1,2 Gew.-%. Der Anteil an Propandiol und Butandiol liegt in einer bevorzugten Ausführungsform in Summe bei < 2 Gew.-% und besonders bevorzugt bei < 1 Gew.-%. Der Anteil an Cyclohexandimethanol (Monomer für PETG) liegt in einer bevorzugten Ausführungsform bei < 3 Gew.-% und besonders bevorzugt bei < 1 Gew.-%.

Tendenziell verringern alle Dicarbonsäurekomponenten, die von TA und NDA abweichen, die Hydrolysebeständigkeit und die Durchschlagfestigkeit. Der Anteil an Isophthalsäure (IPA) liegt in einer bevorzugten Ausführungsform bei < 4 Gew.-% und besonders bevorzugt bei < 1 Gew.-%. Der Anteil anderer Dicarbonsäuren außer TA, NDA und IPA liegt in einer bevorzugten Anwendung aus den genannten Gründen bei < 3 Gew.-% und besonders bevorzugt bei < 1 Gew.-%.

Die Folie gemäß der Erfindung kann weiterhin anorganische oder organische Partikel, die zur Einstellung der Oberflächentopographie oder Optik (Glanz, Trübung, etc) benötigt werden, enthalten. Solche Partikel sind z. B. Kalziumcarbonat, Apatit, Siliziumdioxid, Titandioxid, Aluminiumoxid, vernetztes Polystyrol, vernetztes Polymethylmethacrylat (PMMA), Zeolithe und andere Silikate wie Aluminiumsilikate. Diese Verbindungen werden im Allgemeinen in Mengen von 0,05 bis 5 Gew.-%, vorzugsweise 0,1 bis 0,6 Gew.-%, (bezogen auf das Gewicht der Folie) eingesetzt. Besonders bevorzugt sind dabei Kalziumcarbonat und Siliziumdioxid.

Die eingesetzten mittleren Teilchengrößen ($d_{50}$) liegen zum Erreichen einer guten Laufsicherheit in der Produktion im Allgemeinen zwischen 0,1 und 20 $\mu$m und bevorzugt zwischen 0,3 und 7 $\mu$m und besonders bevorzugt zwischen 0,5 und 5 $\mu$m. Faserförmige anorganische Zuschlagstoffe wie Glasfasern sind ungeeignet, da sie die Produktion der Polyesterfolie durch viele Abrisse unwirtschaftlich machen.

In einer bevorzugten Ausführungsform ist die Folie weiß. Die Weißpigmente können identisch mit den oben genannten Partikeln zur Verbesserung der Wickelbarkeit sein, müssen dann aber in ausreichender Menge und Partikelgröße zugegeben werden, um eine Weißfärbung zu erzielen. Als Weißpigment eignen sich insbesondere Titandioxid, Bariumsulfat, Zinkoxid, $CaCO_3$ oder inkompatible Polymere wie Polypropylen, Polyethylen oder COC oder Kombinationen daraus. Diese werden dem Polyester zu 1 bis 35 Gew.-% zugegeben, wobei die bevorzugte Zugabemenge zwischen 2 und 20 Gew.-% (bezogen auf das Gesamtgewicht der Folie) liegt. Besonders bevorzugt enthält die Folie in dieser Ausführungsform zwischen 3 und 10 Gew.-% (bezogen auf das Gesamtgewicht der Folie) Weißpigment. Die eingesetzten mittleren Teilchengrößen $d_{50}$ liegen zum Erreichen einer guten Laufsicherheit und Weißgrad im Allgemeinen zwischen 0,05 und 5 $\mu$m und bevorzugt zwischen 0,1 und 1 $\mu$m. Die bevorzugten Weißpigmente sind Zinkoxid und Titandioxid, besonders bevorzugt ist Titandioxid. Der Zusatz von $TiO_2$ ist dann besonders bevorzugt, wenn das $TiO_2$ anorganisch beschichtet und optional zusätzlich organisch beschichtet ist. Der Zusatz des $TiO_2$ bewirkt einerseits die Weißfärbung der Folie (wie auch bei Verwendung anderer Weißpigmente) und führt aufgrund einer erhöhten Lichtreflexion zu einer Erhöhung der elektrischen Ausbeute beim Einsatz der Folie für Backsheets von Solarmodulen und anderseits zu einer Verbesserung der UV-Beständigkeit der Folie bzw. des Backsheets, was beim Außeneinsatz des Solarmoduls von besonderem Vorteil ist. Die anorganische Beschichtung reduziert die katalytisch wirksame Oberfläche des $TiO_2$, die zu einer Vergilbung der Folie führen kann, während sich die organische Beschichtung positiv auf die Einarbeitung des $TiO_2$

in den thermoplastischen Polyester auswirkt. Der mittlere Teilchendurchmesser $d_{50}$ des $TiO_2$ liegt bevorzugt im Bereich von 0,1 bis 0,5 μm, besonders bevorzugt 0,15 bis 0,3 μm. Die Zusatzmenge des $TiO_2$ liegt zweckmäßigerweise bei 2 bis 25 Gew.-%, bevorzugt bei 3 bis 12 Gew.-% und besonders bevorzugt bei 4 bis 8 Gew.-%. Die beste Lichtreflexion und der beste UV-Schutz werden erreicht, wenn $TiO_2$ in der Rutilmodifikation benutzt wird.

Neben den erwähnten Additiven kann die Folie zusätzlich weitere Komponenten wie Flammschutzmittel (bevorzugt organische Phosphorsäureester) und/oder UV-Stabilisatoren enthalten. Eine Auswahl geeigneter UV-Stabilisatoren findet sich in FR-A-2812299. Besonders bevorzugt sind UV-Stabilisatoren auf Triazinbasis, da insbesondere diese eine ausreichende Langzeitstabilität (gefordert sind in Solarmodulen meist mehr als 20 Jahre) aufweisen. UV-Stabilisatoren auf Basis von Triazinen werden in einer bevorzugten Ausführungsform zwischen 0,1 und 5 Gew.-% zugegeben (bezogen auf das Gesamtgewicht der Schicht, der sie zugegeben werden). Insbesondere bei weißen Ausführungen führt eine Zugabe von UV-Stabilisator zu einer Schicht unterhalb der der Lichtquelle zugewandten Schicht nicht mehr zu einer nennenswerten Verbesserung der UV-Stabilität. Daher erfolgt bei mehrschichtigen Folien (und insbesondere bei weißen Ausführungen) eine Zugabe des UV-Stabilisators insbesondere in den/der Deckschicht/en, und die Schicht/en unterhalb der Deckschicht/en enthalten den UV-Stabilisator gar nicht oder nur über den Eintrag über Regenerat, also bevorzugt weniger als 60 % und besonders bevorzugt weniger als 30 % des Gewichtsprozentanteils an Stabilisator, den die Deckschicht/en enthalten.

Für eine gute UV-Beständigkeit der Folie hat es sich als günstig erwiesen, wenn die Transparenz im UV-A-Bereich bei 370 nm bei < 20 % und bevorzugt bei < 10 % und idealerweise bei kleiner 5 % liegt.

Weiterhin hat es sich als günstig erwiesen, wenn der Folie ein Stabilisator in Form eines Radikalfängers hinzugegeben wird, da dadurch ebenfalls die thermische Langzeitstabilität verbessert werden kann. Zweckmäßigerweise enthält die erfindungsgemäße Folie solche Stabilisatoren als Radikalfänger bzw. Thermostabilisatoren in Mengen von 50 bis 15.000 ppm, bevorzugt 100 bis 5.000 ppm, besonders bevorzugt 300 bis 1000 ppm, bezogen auf das Gewicht der Folie. Die dem Polyesterrohstoff zugegebenen Stabilisatoren werden beliebig ausgewählt aus der Gruppe der primären Stabilisatoren wie sterisch gehinderte Phenole oder sekundäre aromatische Amine oder der Gruppe der sekundären Stabilisatoren wie Thioether, Phosphite und Phosphonite sowie Zink-dibutyl-dithiocarbamat oder synergistische Mischungen aus primären und sekundären Stabilisatoren. Bevorzugt sind die phenolischen Stabilisatoren. Zu den phenolischen Stabilisatoren zählen insbesondere sterisch gehinderte Phenole, Thio-bisphenole, Alkyliden-bisphenole, Alkyl-phenole, Hydroxybenzyl-Verbindungen, Acyl-amino-phenole und Hydroxyphenylpropionate (entsprechende Verbindungen sind beispielsweise beschrieben in "Kunststoffadditive", 2. Ausgabe, Gächter Müller, Carl Hanser-Verlag, und in "Plastics Additives Handbook", 5. Ausgabe, Dr. Hans Zweifel, Carl Hanser-Verlag). Besonders bevorzugt sind die Stabilisatoren mit folgenden CAS-Nummern: 6683-19-8, 36443-68-2, 35074-77-2, 65140-91-2, 23128-74-7, 41484-35-9, 2082-79-3 sowie Irganox® 1222 der Firma Ciba Specialities, Basel, CH, wobei in besonderen Ausführungsformen die Typen Irganox® 1010, Irganox® 1222, Irganox® 1330 und Irganox® 1425 oder Mischungen daraus bevorzugt sind.

Die erfindungsgemäße Folie enthält zudem 10 bis 500 ppm, bevorzugt 20 bis 80 ppm Kupfer in Form eines Kupfersalzes als Teil eines Decarboxylierungskatalysatorsystems. Das Salz ist bevorzugt ein Salz von Cu(II), also Kupfer in der Oxidationsstufe 2. Es kann aber auch ein Cu(I)-Salz sein, wobei das Salz dem Rohstoff bevorzugt als Cu(II)-Salz zugegeben wird, da bei der Zugabe von Cu(I)-Salzen unerwünschte Verfärbungen auftreten können.

Das Gegenion ist bevorzugt das ein- oder mehrwertige Anion einer Carbonsäure (wie Essigsäure oder Benzoesäure), eines Amids oder eines Acetylanalogens einer Carbonsäure (wie Acetylacetonat), wobei Amide aufgrund einer Verfärbungstendenz weniger bevorzugt sind. Auch andere Anionen wie Sulfat, Carbonat können verwendet werden, führen aber in der Regel zu einer geringeren Löslichkeit des Kupfersalzes im Polyester und damit zu einer deutlich geringeren Reaktionsgeschwindigkeit und sind daher weniger bevorzugt. Besonders bevorzugt sind die Anionen kurzkettiger Carbonsäuren mit weniger als 8 und besonders bevorzugt weniger als 5 und insbesondere weniger als 4 Kohlenstoffatomen, wobei Salze der Ameisensäure weniger bevorzugt sind.

Neben dem Kupfersalz enthält die Folie ein Halogenid ausgewählt aus Jodid, Chlorid oder Bromid, wobei Jodid zu deutlich besseren Ergebnissen hinsichtlich der Decarboxilierung führt und daher bevorzugt ist. Das Halogenid wird bevorzugt in Form von Alkalimetallsalzen zugegeben, wobei hier mit Kaliumsalzen die besten Decarboxilierungsergebnisse erzielt werden.

Die Folie enthält 15 bis 600 ppm Halogenid, wobei 30 bis 250 ppm bevorzugt sind. In einer bevorzugten Ausführungsform beträgt das Mol-Verhältnis Hal/Cu 0,5 bis 3,5 (Hal = $J^-$, $Br^-$ oder $Cl^-$ ohne Gegenion, Cu = Cu(I) oder Cu(II), bevorzugt Cu(II)), besonders bevorzugt beträgt das Mol-Verhältnis 0,75 bis 3,0 und ganz besonders bevorzugt 0,8 bis 1,0. Wird das Mol-Verhältnis unterschritten, so ist die Reaktionsgeschwindigkeit unzureichend und die Decarboxilierung unvollständig. Liegt das Mol-Verhältnis bei deutlich über 3,5, so kommt es zu einer starken Gasentwicklung in der Extrusion und zu einer deutlichen Verfärbung der Folie.

In einer bevorzugten Ausführungsform wird mindestens einem der zur Folienherstellung verwendeten Polymerrohstoffe neben dem Halogenid ein weiteres, von Halogenid verschiedenes, Reduktionsmittel zugesetzt, wobei es sich bevorzugt um Hypophosphit oder Orthophosphit handelt. Hierdurch kann die Menge an Halogenid reduziert und

somit Verfärbungen reduziert werden. Das zusätzliche Reduktionsmittel wird bevorzugt im Molverhältnis von Kupfer(II) zu zusätzlichem Reduktionsmittel von 0,5 bis 2,5 zugegeben.

Das Decarboxilierungskatalysatorgemisch aus Kupfersalz, Halogenid und gegebenenfalls zusätzlichem Reduktionsmittel wird bevorzugt bei der Polyesterherstellung zu Beginn der Polykondensation hinzugegeben. Wenn vor der Polykondensation eine Umesterung erfolgt (bei Verwendung von Dimethylterephthalat (DMT)) wird das Katalysatorgemisch bevorzugt zum Ende der Umesterung und vor der Polykondensation hinzugegeben. Eine Zugabe während oder auch am Ende der Polykondensation ist ebenfalls möglich, führt aber zu schlechteren Hydrolyseschutzresultaten und zu mehr Gasentwicklung bei der Folienherstellung und ist daher weniger bevorzugt. Dass die Zugabe wirkungsvoll auch vor der Polykondensation erfolgen kann, ist insofern überraschend als in GB 1,048,068 und in US-A-3,446,766 eine Zugabe zum Ende der Polykondensation empfohlen wird.

Überraschenderweise hat sich herausgestellt, dass die Hydrolysegeschwindigkeit nahezu im gleichen Maß reduziert wird, wenn das Decarboxilierungskatalysatorsystem gleichmäßig in 100 Gew.-% der Polyesterrohstoffe enthalten ist oder quasi als Katalysator-Masterbatch nur einem Teil der Polyesterrohstoffe zugegeben wird. Bevorzugt enthalten wenigstens 20 Gew.-% der Polyesterrohstoffe und besonders bevorzugt wenigstens 50 Gew.-% der Polyesterrohstoffe das Katalysatorsystem. Wichtig ist dabei, dass die Gehalte an Kupfersalz und Halogenid der Gesamtpolyestermischung den oben genannten Mengen entsprechen.

Ebenfalls überraschend war, dass auch die Verwendung von bis zu 50 Gew.-% Eigenregenerat nicht zu einer deutlichen Erhöhung der Hydrolysegeschwindigkeit führt, während bei der Verwendung von Rohstoffen mit niedrigen Carboxylendgruppengehalten ohne Verwendung eines Decarboxylierungskatalysatorsystems bereits 25 Gew.-% Regenerat ausreichen, um die Hydrolysegeschwindigkeit um mehr als 30 % ansteigen zu lassen.

In einer bevorzugten Ausführungsform enthält die Folie neben dem aus Kupfersalz und Halogenid (und gegebenenfalls weiteren Reduktionsmitteln) bestehenden Decarboxilierungskatalysatorsystem einen oder mehrere Hydrolysestabilisatoren wie Cabodiimide oder epoxidierte Fettsäurederivate, wobei epoxidierte Fettsäurederivate bevorzugt sind (weniger irritierende Ausgasungen). Carbodiimide sind zwar - wie oben dargelegt - nachteilig; sofern sich diese Nachteile aber anderweitig beseitigen lassen oder wenn diese Nachteile keine Rolle spiele, können diese ansonsten sehr wirksamen Hydrolysestabilisatoren, ggf. in Kombination mit den erfindungsgemäßen z. B. in reduzierter Menge eingesetzt werden. Besonders bevorzugt ist epoxidiertes Leinöl. Decarboxilierungskatalysator und Hydrolysestabilisator zeigen dabei eine unerwartete synergistische Wirkung (Hydrolysestabilität), obwohl die genannten Hydrolysestabilisatoren Carboxylendgruppen zur Entfaltung ihrer Wirkung benötigen, die durch das Katalysatorsystem stark reduziert werden.

Weiterhin können der Folie bei der Herstellung Kettenverlängerer wie Oxazoline oder mehrere Gycidylgruppen enthaltende Verbindungen (direkt oder in Form eines Masterbatches) zugegeben werden, um die initiale Kettenlänge des Polymers in der Folie zu erhöhen. Kettenverlängerer unterscheiden sich von den Hydrolysestabilisatoren dadurch, dass ihre reaktiven Gruppen zu über 90 % bereits in der Extrusion abreagieren und daher nur dort kettenverlängernd wirken, aber während der Verwendungszeit der Folie nicht mehr als Hydrolysestabilisator zur Verfügung stehen. Bevorzugte Kettenverlängerer sind Polymere, die durch Formel 1 beschrieben werden. Formel 1:

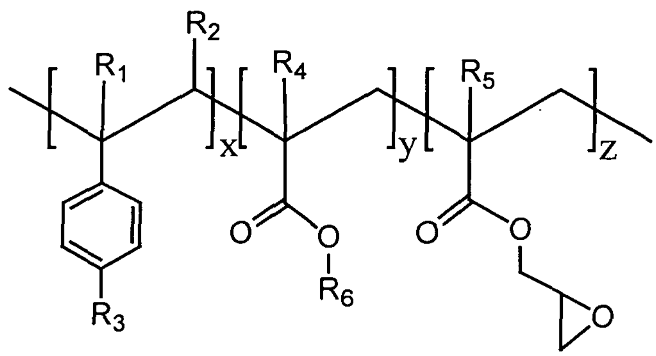

$R_1$ - $R_5$ sind dabei unabhängig voneinander H oder ein $C_1$- bis $C_{12}$-Alkylrest, bevorzugt $CH_3$.
$R_6$ ist eine $C_1$- bis $C_{12}$-Alkylgruppe, bevorzugt $CH_3$.
x und y liegen zwischen 0 und 100 und bevorzugt zwischen 1 und 20.
x + y ist größer als 0 und bevorzugt größer als 10.
z liegt zwischen 2 und 100, bevorzugt zwischen 3 und 20 und besonders bevorzugt zwischen 3 und 10.

Diese Angaben beziehen sich auf das Mittel der eingesetzten Polymere (Kettenverlängerer), da einzelne Polymerketten in sich statistisch verteilte Monomeranteile aufweisen können, die von den bevorzugten Bereichen abweichen können. Diese Verbindungen zeichnen sich durch eine besonders gute Einbindung in die Polyestermatrix aus und haben gleichzeitig eine sehr gute Ketten verlängernde Wirkung bei geringer Gelbildungstendenz. Dies gilt insbesondere dann, wenn mindestens zwei der drei Monomerbestandteile x, y und z gleichzeitig innerhalb der Vorzugsbereiche liegen. Solche Polymere werden von BASF AG unter dem Markennamen Joncryl® ADR vertrieben. Besonders bevorzugt sind dabei die flüssigen Produkte. Diese Polymere (Kettenverlängerer) werden üblicherweise zu weniger als 2 Gew.-% dosiert und besonders bevorzugt zu weniger als 1,2 Gew.-%. Es wird dabei üblicherweise mindestens 0,05 Gew.-%, bevorzugt mindestens 0,1 Gew.-% und besonders bevorzugt mindestens 0,2 Gew.-% (bezogen auf das Gesamtgewicht der Folie) dosiert.

In einer bevorzugten Ausführungsform liegt die Menge an Hydrolysestabilisator + Kettenverlängerer + UV-Schutzmittel bei < 10 Gew.-% und besonders bevorzugt bei < 7 Gew.-% und insbesondere < 5 Gew.-%, da diese Substanzen zwar die Bewitterungsfestigkeit (UV-Abbau und Hydrolyse) verbessern, gleichzeitig aber auch das Polyesternetzwerk stören und so tendenziell die Durchschlagfestigkeit herabsetzen.

Die Kettenverlängerer und Hydrolysestabilisatoren werden bevorzugt direkt bei der Folienherstellung in den Extruder dosiert. Besonders bevorzugt ist dabei, wenn die Viskosität der Schmelze im Prozess (on-line) gemessen wird und die Dosierung des Kettenverlängerers so geregelt wird, dass eine konstante Viskosität in der Extrusion erreicht wird.

Der Kettenverlängerer kann aber auch bei der Rohstoffherstellung oder bei der Regeneratherstellung zugegeben werden. Eine bevorzugte Stelle bei der Regeneratherstellung ist die Zugabe in die Extrusion bei der Herstellung des Regranulats aus den Produktionsrückständen der Folienproduktion. Der SV-Wert der Regenerate wird dabei über die Dosierung der Kettenverlängerer zweckmäßigerweise so eingestellt, dass er dem mittleren SV-Wert der sonstigen Rohstoffe, die bei der erneuten Folienherstellung eingesetzt werden, entspricht.

Bevorzugt werden Mehrschneckenextruder (mindestens 2 Schnecken) eingesetzt.

Der/die Kettenverlängerer/Hydrolysestabilisator/en kann auch über die Masterbatchtechnologie eingebracht werden. D. h. der/die Kettenverlängerer/Hydrolysestabilisator/en (zusammen oder separat) wird/werden in einem Extruder (bevorzugt ein Mehrschneckenextruder) in das Polymer eingebracht. Diese/s Polymer/e wird/werden dann bei der Folienherstellung pur oder mit anderen Polymeren gemischt erneut extrudiert. Dieses Verfahren ist jedoch weniger bevorzugt, da bereits im ersten Extrusionsschritt Kettenverlängerer verbraucht (abreagiert) wird, welcher dann in der Folie nicht mehr als aktive Substanz zur Verfügung steht. Es müssen also besonders schonende Extrusionsbedingungen gewählt werden, die anders als bei der Folienherstellung nicht zu einem vollständigen (> 75 %) Abreagieren der aktiven Gruppen führen. Dies kann z. B. durch die Wahl von Copolyestern mit niedrigerem Schmelzpunkt (z. B. Polymere mit mehr als 5 Gew.-%, bevorzugt mehr als 10 Gew.-%, IPA (Isophthalsäure)) und durch eine späte Zugabe des Kettenverlängerers im Extruder, d. h. nicht direkt im Einzugsbereich, erreicht werden. Dies wirkt sich aber negativ auf die Hydrolysegeschwindigkeit der erfindungsgemäßen Folien aus und ist daher weniger bevorzugt.

Die Folie gemäß der Erfindung wird im Allgemeinen nach an sich bekannten Extrusionsverfahren hergestellt und ist ein- oder mehrschichtig, wobei das Decarboxilierungskatalysatorsystem und gegebenenfalls die weiteren Additive wie Kettenverlängerer/Hydrolysestabilisatoren in allen Schichten enthalten sein kann, jedoch auch Ausführungen möglich sind, in denen nicht alle Schichten mit den Additiven bzw. mit dem Katalysatorsystem ausgerüstet sind. In einer bevorzugten Ausführungsform enthalten mindestens alle Außenschichten das Decarboxilierungskatalysatorsystem, da eine hydrolysebedingte Versprödung außen einen größeren Einfluss auf die Stabilität der Gesamtfolie hat als eine Versprödung einer innen liegenden Schicht, die durch die stabilisierten Deckschichten zusammen gehalten wird.

Die Foliendicke der erfindungsgemäßen Folien liegt zwischen 6 und 500 $\mu$m und bevorzugt zwischen 36 und 350 $\mu$m und besonders bevorzugt zwischen 49 und 300 $\mu$m.

Bei dem Verfahren zur Herstellung der erfindungsgemäßen Folie wird zweckmäßigerweise so vorgegangen, dass die den einzelnen Schichten entsprechenden Schmelzen durch eine Flachdüse extrudiert werden, die so erhaltene Folie zur Verfestigung auf einer oder mehreren Walze/n (Kühlwalze) als weitgehend amorphe Vorfolie abgezogen und abgeschreckt wird, die Folie anschließend erneut erhitzt und biaxial gestreckt (orientiert) und die biaxial gestreckte Folie thermofixiert wird.

Es hat sich als günstig erwiesen, wenn die Temperaturen in der gesamten Extrusion 295 °C nicht überschreiten und bevorzugt 285 °C und idealerweise 280 °C nicht überschreiten, da es ansonsten zu einer deutlichen Blasenbildung in der Folie kommt.

Zur Vermeidung von Blasen hat es sich zudem als günstig erwiesen, wenn die Rohstoffe, welche das Decarboxilierungssystem enthalten, in einem Zweischneckenextruder aufgeschmolzen und extrudiert werden.

Die biaxiale Verstreckung wird im Allgemeinen sequentiell durchgeführt. Dabei wird vorzugsweise erst in Längsrichtung (d. h. in Maschinenrichtung = MD-Richtung) und anschließend in Querrichtung (d. h. senkrecht zur Maschinenrichtung = TD-Richtung) verstreckt. Dies führt zu einer Orientierung der Molekülketten. Das Verstrecken in Längsrichtung lässt sich mit Hilfe zweier entsprechend dem angestrebten Streckverhältnis verschieden schnell laufender Walzen durchführen. Zum Querverstrecken benutzt man allgemein einen entsprechenden Kluppenrahmen.

Die Temperatur, bei der die Verstreckung durchgeführt wird, kann in einem relativ großen Bereich variieren und richtet sich nach den gewünschten Eigenschaften der Folie. Im Allgemeinen wird die Längs- und auch die Querstreckung bei $T_g$ + 10 °C bis $T_g$ + 60 °C (Tg = Glastemperatur der Folie) durchgeführt. Das Längsstreckverhältnis liegt allgemein im Bereich von 2,0 : 1 bis 6,0 : 1, vorzugsweise 3,0 : 1 bis 4,5 : 1. Das Querstreckverhältnis liegt allgemein im Bereich von 2,0 : 1 bis 5,0 : 1, vorzugsweise 3,0 : 1 bis 4,5 : 1, und das einer gegebenenfalls durchgeführten zweiten Längs- und Querstreckung liegt bei 1,1 : 1 bis 5,0 : 1.

Die Längsstreckung kann gegebenenfalls gleichzeitig mit der Querstreckung (Simultanstreckung) durchgeführt werden.

Zum Erreichen der gewünschten guten elektrischen Isoliereigenschaften hat es sich als günstig erwiesen, wenn das Flächenstreckverhältnis (längs mal quer) größer ist als 5 bzw. besser größer 7,5 und besonders bevorzugt größer 9,5 ist. Ein Flächenstreckverhältnis oberhalb von 22 hat sich als ungünstig hinsichtlich der Laufsicherheit der Folie erwiesen. Flächenstreckverhältnisse größer 25 sollten ebenfalls nicht angestrebt werden, da es in diesem Bereich lokal bereits wieder zu einem Rückgang der Durchschlagfestigkeit kommt. Die genannten Flächenstreckverhältnisse führen zu Folien, die bevorzugt in jeder Folienrichtung einen E-Modul von größer 2500 $N/mm^2$ und besonders bevorzugt in jeder Folienrichtung größer 3000 $N/mm^2$ und ganz bevorzugt in jeder Folienrichtung größer 3500 $N/mm^2$ aufweisen und bevorzugt in keiner Folienrichtung ein E-Modul von größer 7000 N/ $mm^2$ aufweisen.

Die genannten Streckverhältnisse führen zu Folien, die eine ausreichende Reißdehnung aufweisen, um in den Rückseitenisolationen von Solarmodulen flexibel genug zu sein für die mechanischen Belastungen während der Fertigung und in der Anwendung (z. B. Windlast). Die Reißdehnung sollte in jeder Folienrichtung größer 10 % sein und liegt bevorzugt in jeder Folienrichtung größer 25 % und besonders bevorzugt größer 50 %. Für das Erreichen dieser Reißdehnungswerte hat es sich als günstig erwiesen, wenn das Flächenstreckverhältnis kleiner ist als 20 und besser kleiner ist als 18.

Bei der sich an die Streckung anschließenden Thermofixierung wird die Folie etwa 0,1 bis 10 s lang bei einer Temperatur von 150 bis 260 °C, vorzugsweise 200 bis 245 °C, gehalten. Anschließend an beziehungsweise beginnend in der Thermofixierung wird die Folie um 0,5 bis 15 %, vorzugsweise um 2 bis 8 %, in Quer- und gegebenenfalls auch in Längsrichtung relaxiert und die Folie dann in üblicher Weise abgekühlt und aufgewickelt.

In einer bevorzugten Ausführungsform liegt der Schrumpf der erfindungsgemäßen Folien bei 150 °C (15 min) in beiden Folienrichtungen (MD und TD) unterhalb von 2 %, bevorzugt unterhalb von 1,5 % und besonders bevorzugt in beiden Folienrichtungen unterhalb von 1,3 %. Dies kann erreicht werden, indem die maximale Temperatur in der Fixierung größer 210 °C und bevorzugt größer 230 °C und besonders bevorzugt größer 238 °C eingestellt wird. Bevorzugt liegt zu dem gleichen Zweck die Relaxation in Querrichtung oberhalb von 3 %, und bevorzugt werden mindestens 30 % dieser Relaxation bei Temperaturen unterhalb von 200 °C durchgeführt. Der niedrige Schrumpf ist insbesondere für den Einsatz in Rückseitenlaminaten von Solarmodulen wichtig, da beim Laminierprozess höhere Temperaturen auftreten, die bei höheren Schrumpfwerten zu größeren Folienverlusten führen und zudem Wellen und Falten erzeugen können.

Folien, die das erfindungsgemäße Decarboxilierungskatalysatorsystem enthalten, eignen sich hervorragend für Elektroisolieranwendungen, insbesondere wenn lange Lebensdauer (Jahre) und höhere Temperaturen (> 60 °C) und Luftfeuchte (mehr als 10 % relative Luftfeuchte) vorherrschen, da die erfindungsgemäßen Folien ihre guten elektrischen Eigenschaften auch unter feuchten Wärmebedingungen für lange Zeit erhalten. Solche Anwendungen sind z. B. Flachbandkabel in Automobilen, Kabel in Sitzheizungen, Motorisolation und vor allem die Rückseitenisolation in Solarmodulen. Die Folie kann dabei sowohl alleine, als auch als Laminat mit anderen Folien eingesetzt werden. Ein typisches Laminat ist in der Figur 1 abgebildet, wobei 1 eine 50 μm weiße Polyesterfolie mit Decarboxilierungskatalysatorsystem ist, 2 ist eine 12 μm SiOx bedampfte Polyesterfolie (z. B. X-Barrier von Mitsubishi Plastics, Inc., JP), 3 ist eine 100 μm weiße Polyesterfolie (z. B. Hostaphan WDW/WUV oder WO/UVO), 4 ist eine Kleberschicht, und 5 ist eine Kleberschicht zum Einbettungsmaterial EVA des Solarmoduls.

In den nachfolgenden Ausführungsbeispielen erfolgt die Messung der einzelnen Eigenschaften gemäß den angeführten Normen bzw. Verfahren.

**Messmethoden**

**Standardviskosität (SV)**

Die Standardviskosität SV wird - angelehnt an DIN 53726 - durch die Messung der relativen Viskosität $\eta_{rel.}$ einer 1 Gew.-%igen Lösung in Dichloressigsäure (DCE) in einem Ubbelohde-Viskosimeter bei 25 °C gemessen. Der SV-Wert ist wie folgt definiert:

$$SV = (\eta_{rel.} - 1) \bullet 1000$$

**Schrumpf**

Der thermische Schrumpf wird an quadratischen Folienmustern mit einer Kantenlänge von 10 cm bestimmt. Die Proben werden so ausgeschnitten, dass eine Kante parallel zur Maschinenrichtung und eine Kante senkrecht zur Maschinenrichtung verläuft. Die Proben werden genau ausgemessen (die Kantenlänge $L_0$ wird für jede Maschinenrichtung TD und MD bestimmt, $L_{0\,TD}$ und $L_{0\,MD}$) und werden 15 min bei der angegeben Schrumpfungstemperatur (hier 150 °C) in einem Umlufttrockenschrank getempert. Die Proben werden entnommen und bei Raumtemperatur genau ausgemessen (Kantenlänge $L_{TD}$ und $L_{MD}$). Der Schrumpf ergibt sich aus der Gleichung

$$\text{Schrumpf [\%] MD} = 100 \bullet (L_{0\,MD} - L_{MD}) / L_{0\,MD}$$

$$\text{Schrumpf [\%] TD} = 100 \bullet (L_{0\,TD} - L_{TD}) / L_{0\,TD}$$

**Messung der Transparenz bei 370 nm**

Die Messung der Transparenz erfolgt mit einem Lambda 3 UV/Vis Spektrometer der Firma Perkin Elmer.

**Messung der Spannungsfestigkeit / Durchschlagfestigkeit**

Die Messung der Spannungsfestigkeit erfolgt gemäß DIN 53481-3 (unter Berücksichtigung von DIN 40634 für die speziellen Folienanweisungen). Es wird mittels Kugel/Platte (Elektrodendurchmesser 49,5 mm) bei einer sinusförmigen Wechselspannung von 50 Hz bei 23 °C und 50 rel. Luftfeuchte in Luft gemessen.

**Messung des mittleren Partikeldurchmessers $d_{50}$ an Partikeln vor der Einbringung in den Rohstoff**

Die Bestimmung des mittleren Partikeldurchmessers $d_{50}$ wird mittels Laser auf einem Master Sizer (Malvern Instruments, UK) nach der Standardmethode durchgeführt (andere Messgeräte sind z. B. Horiba LA 500 (Horiba Ltd., JP) oder Helos (Sympatec GmbH, DE), welche das gleiche Messprinzip verwenden). Die Proben werden dazu in eine Küvette mit Wasser gegeben und diese dann in das Messgerät gestellt. Der Messvorgang ist automatisch und beinhaltet auch die mathematische Bestimmung des $d_{50}$-Wertes. Der $d_{50}$-Wert wird dabei definitionsgemäß aus der (relativen) Summenkurve der Partikelgrößenverteilung bestimmt: Der Schnittpunkt des 50 %-Ordinatenwertes mit der Summenkurve liefert auf der Abszissenachse den gewünschten $d_{50}$-Wert.

**Messung der mechanischen Eigenschaften der Folie**

Die Bestimmung der mechanischen Eigenschaften erfolgt nach DIN EN ISO 527-1 bis 3.

**Autoklavierung**

Die Folien (10 x 2 cm) werden an einem Draht in den Autoklaven (Adolf Wolf SANOklav Typ: ST-MCS-204) gehängt und der Autoklav mit 2 l Wasser befüllt. Nach dem Schließen des Autoklaven wird dieser erhitzt. Bei 100 °C wird die Luft durch den Wasserdampf über das Ablassventil verdrängt. Dies wird nach ca. 5 min geschlossen, worauf die Temperatur auf 110 °C und der Druck auf 1,2 bis 1,5 bar ansteigen. Nach der eingestellten Zeit wird der Autoklav automatisch abgeschaltet und nach Öffnen des Ablassventils die Folien entnommen. An diesen wird dann der SV-Wert bestimmt.

**Beispiele**

Verfahren: Die Rohstoffe wurden gemischt und in einem Zweischneckenextruder der Firma Japan Steel Works mit Entgasung extrudiert. In den Extruderzonen und in der Schmelzeleitung betrug die Temperatur maximal 278 °C. Der Durchsatz betrug 2000 kg pro Stunde. Die Schmelze wurde durch eine Breitschlitzdüse (Temperatur 280 °C) auf eine Kühlwalze (30 °C) extrudiert und anschließend bei 110 °C um den Faktor 3,2 in Längsrichtung gestreckt und dann bei 115 °C um den Faktor 3,5 in Querrichtung gestreckt.

Die Folie wurde dann bei 180 bis 242 °C (ein Fixierfeld 180 °C und 2 Fixierfelder 242 °C) fixiert, wobei im letzten Feld 2 % Relaxation in Querrichtung eingestellt wurden. In den beiden folgenden Fixierfeldern waren 190 °C und 150

°C eingestellt, und die Relaxation hier betrug weitere 3 %. Die Gesamtverweilzeit in der Fixierung betrug 15 s.

Verwendete Rohstoffe:

R1 = Polyethylenterephthalat Typ 8610 (Hersteller Invista, USA), festphasenkondensiert bis ein IV = 0,68 erreicht wurde (gemessen wie in US-A-3,432,591 angegeben), SV = 885; der Carboxylendgruppengehalt CEG lag bei 10 mmol/kg (gemessen wie in EP-A-0 738 749 angegeben). Der niedrige CEG wurde ohne Decarboxylierungskatalysator oder andere Additive nur über die akribische Prozesskontrolle erreicht. IPA Gehalt < 0,3 Gew.-% und DEG = 1,0 Gew.-%.

R2 = 40 Gew.-% Polyethylentherephthalat und 60 Gew.-% $TiO_2$, Ti-Pure® R-104 von DuPont, USA, hergestellt durch Einkneten des $TiO_2$ in den Polyester in einem Zweischneckenextruder. Der SV-Wert betrug 700 und der CEG-Gehalt 50 mmol/kg (bezogen auf den Polymeranteil) und DEG = 1,2 Gew.-% (bezogen auf den Polymeranteil).

R3 = Polyethylentherephthalat RT49 von Invista, DE, mit einem SV = 810 und einem CEG = 19 mmol/kg und einem DEG = 0,61 Gew.-%.

R4 = Polyethylentherephthalat mit 200 g/t Kupfer(II)Acetat-Monohydrat (CAS 6046-93-1) und 150 g/t Kaliumjodid (CAS 7681-11-0) und 50 g/t Natriumhypophosphit-Monohydrat (CAS 10039-56-2) mit einem SV von 890 und einem DEG von 0,9 Gew.-% und einem CEG von 9 mmol/kg. Zugabe Kupfersalz, Jodid und Hypophosphit nach Abschluss der Umesterung.

R5 = Polyethylentherephthalat mit 400 g/t Kupfer(II)Acetat-Monohydrat (CAS 6046-93-1) und 350 g/t Kaliumjodid (CAS 7681-11-0) und 100 g/t Natriumhypophosphit-Monohydrat (CAS 10039-56-2) mit einem SV von 850 und einem DEG von 1,2 Gew.-% und einem CEG von 6 mmol/kg. Zugabe Kupfersalz, Jodid und Hypophosphit nach Abschluss der Umesterung.

R6 = epoxidiertes Leinöl mit einem Epoxidsauerstoffgehalt von 8,9 % von Arkema, USA.

Die Folieneigenschaften können der Tabelle 1 entnommen werden.

**Tabelle 1**

| | | Beispiel | | | | Vergleichsbeispiel | |
|---|---|---|---|---|---|---|---|
| Eigenschaft | Rohstoff | 1 | 2 | 3 | 4 | 1 | 2 |
| | R1 (Gew.-%) | | | | | 91 | 70,5 |
| | R2 (Gew.-%) | 9 | 4,5 | 9 | 9 | 9 | 4,5 |
| | R3 (Gew.-%) | | | 41 | | | |
| | R4 (Gew.-%) | 91 | 45,5 | | 86 | | |
| | R5 (Gew.-%) | | | 50 | | | |
| | R6 (Gew.-%) | | | | 5 | | |
| | Eigenregenerat (Gew.-%) | 0 | 50 | 0 | 0 | | 25 |
| Dicke | in µm | 50 | 50 | 50 | 50 | 50 | 50 |
| Hydrolysegeschwindigkeit nach 144 h im Autoklaven | in SV/h | -1,6 | -1,75 | -1,6 | -0,35 | -1,95 | -2,7 |
| Schrumpf, längs | in% | 1,20 | 1,10 | 1,00 | 1,20 | 1,20 | 1,20 |
| Schrumpf, quer | in% | 0,20 | 0,30 | 0,10 | 0,40 | 0,30 | 0,20 |
| E-Modul, längs | in $N/mm^2$ | 4215 | 4163 | 4196 | 3876 | 4231 | 4205 |
| E-Modul, quer | in $N/mm^2$ | 4751 | 4623 | 4829 | 4100 | 4718 | 4786 |
| Reißdehnung, längs | in % | 65 | 62 | 61 | 72 | 68 | 63 |
| Reißdehnung, quer | in % | 64 | 65 | 68 | 85 | 71 | 69 |
| Durchschlagfestigkeit | in kV/mm | 328 | 314 | 330 | 292 | 324 | 319 |
| Durchschlagfestigkeit nach 144 h im Autoklav | in kV/mm | 288 | 251 | 278 | 285 | 197 | 74 |
| Transparenz bei 370 nm | in % | <5 | <5 | <5 | <5 | <5 | <5 |

**Patentansprüche**

1. Biaxial gestreckte Folie, deren polymere Bestandteile überwiegend aus einem Polyester bestehen, wobei die Folie mindestens ein Kupfersalz und ein Halogenid enthält, wobei das Mol-Verhältnis Halogenid zu Cu 0,5 bis 3,5 beträgt und wobei die Folie eine Spannungsfestigkeit (Durchschlagfestigkeit) AC (Alternating Current) bei 23 °C und 50 Hz von mindestens 100 kV/mm aufweist, wobei die Messung der Spannungsfestigkeit gemäß DIN 53481-3 unter Berücksichtigung von DIN 40634, für die speziellen Folienanweisungen, erfolgt und mittels Kugel/Platte (Elektrodendurchmesser 49,5 mm) bei einer sinusförmigen Wechselspannung von 50 Hz bei 23 °C und 50 rel. Luftfeuchte in Luft gemessen wird.

2. Folie nach Anspruch 1, **dadurch gekennzeichnet, dass** das Kupfersalz ein Salz von Cu(II) ist.

3. Folie nach Anspruch 1 oder 2, **dadurch gekennzeichnet, dass** das Gegenion des Kupfers in dem Kupfersalz ein ein- oder mehrwertiges Anion einer Carbonsäure, eines Amids oder eines Acetylanalogens einer Carbonsäure ist.

4. Folie nach einem der Ansprüche 1 bis 3, **dadurch gekennzeichnet, dass** das Halogenid ausgewählt ist aus Jodid, Chlorid und Bromid und bevorzugt ein Alkalihalogenid ist.

5. Folie nach einem der Ansprüche 1 bis 4, **dadurch gekennzeichnet, dass** die Folie 15 bis 600 ppm Halogenid enthält (bezogen auf die Masse der Folie).

6. Folie nach einem der Ansprüche 1 bis 5, **dadurch gekennzeichnet, dass** neben dem Halogenid ein weiteres, von Halogenid verschiedenes Reduktionsmittel vorhanden ist.

7. Folie nach Anspruch 6, **dadurch gekennzeichnet, dass** das von Halogenid verschiedene Reduktionsmittel im Molverhältnis von Kupfer(II) zu zusätzlichem Reduktionsmittel von 0,5 bis 2,5 vorhanden ist.

8. Folie nach einem der Ansprüche 1 bis 7, **dadurch gekennzeichnet, dass** die Folie ein epoxidiertes Fettsäurederivat als Hydrolysestabilisatoren enthält.

9. Folie nach einem der Ansprüche 1 bis 8, **dadurch gekennzeichnet, dass** die Folie einen oder mehrere Kettenverlängerer enthält und der Kettenverlängerer ein Polymer ist, das durch Formel 1 beschrieben wird

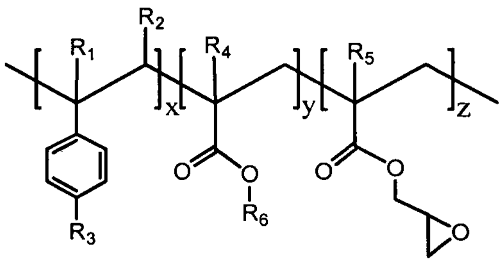

Formel 1

wobei

$R_1$ - $R_5$ unabhängig voneinander H oder ein $C_1$- bis $C_{12}$-Alkylrest ist,
$R_6$ eine $C_1$- bis $C_{12}$-Alkylgruppe ist,
x und y zwischen 0 und 100 liegen,
x + y größer als 0 ist und
z zwischen 2 und 100 liegt,
wobei sich diese Angaben auf das Mittel der eingesetzten Polymere des Kettenverlängerers beziehen.

10. Folie nach Anspruch 9, **dadurch gekennzeichnet, dass** der Kettenverlängerer zu weniger als 2 Gew.-% und mindestens 0,05 Gew.-% in der Folie enthalten ist.

11. Verfahren zur Herstellung einer Folie nach Anspruch 1, wobei die den einzelnen Schichten der Folie entsprechenden Schmelzen durch eine Flachdüse extrudiert werden, die so erhaltene Folie zur Verfestigung auf einer oder mehreren

Walze/n (Kühlwalze) als weitgehend amorphe Vorfolie abgezogen und abgeschreckt wird, die Folie anschließend erneut erhitzt und biaxial gestreckt (orientiert) und die biaxial gestreckte Folie thermofixiert und anschließend aufgewickelt wird und wobei die Folie mindestens ein Kupfersalz und ein Halogenid enthält.

**12.** Verwendung einer Folie nach Anspruch 1 für Elektroisolieranwendungen.

**13.** Laminat, enthaltend mindestens eine Folie nach Anspruch 1 und mindestens eine weitere Folie.

**14.** Solarmodul, enthaltend eine Folie nach Anspruch 1.

**Claims**

**1.** Biaxially stretched film, the polymeric constituents of which are composed mainly of a polyester, where the film comprises at least one copper salt and one halide, where the molar ratio of halide to Cu is from 0.5 to 3.5, and where the AC (alternating current) dielectric strength of the film is at least 100 kV/mm at 23 °C and 50 Hz where the dielectric strength is measured in accordance with DIN 53481-3 with reference to DIN 40634 for the specific instructions relating to films, and is measured with a ball-and-plate system (electrode diameter 49.5 mm) with sinusoidal alternating voltage at 50 Hz, 23°C and rel. humidity 50 in air.

**2.** Film according to Claim 1, **characterized in that** the copper salt is a salt of Cu(II).

**3.** Film according to Claim 1 or 2, **characterized in that** the counterion of the copper in the copper salt is a mono- or polyvalent anion of a carboxylic acid, of an amide, or of an acetyl analog of a carboxylic acid.

**4.** Film according to any of Claims 1 to 3, **characterized in that** the halide has been selected from iodide, chloride, and bromide, and is preferably an alkali metal halide.

**5.** Film according to any of Claims 1 to 4, **characterized in that** the film comprises (based on the mass of the film) from 15 to 600 ppm of halide.

**6.** Film according to any of Claims 1 to 5, **characterized in that**, alongside the halide, another reducing agent different from halide is present.

**7.** Film according to Claim 7, **characterized in that** the amount present of the reducing agent that differs from halide is such that the molar ratio of copper (II) to additional reducing agent is from 0.5 to 2.5.

**8.** Film according to any of Claims 1 to 7, **characterized in that** the film comprises an epoxidized fatty acid derivative as hydrolysis stabilizers.

**9.** Film according to any of Claims 1 to 8, **characterized in that** the film comprises one or more chain extenders, and the chain extender is a polymer described by formula 1

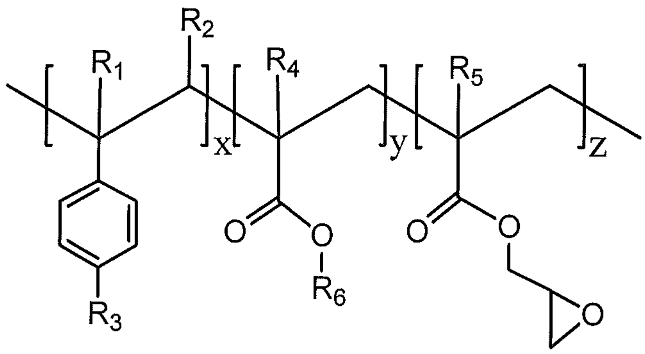

formula 1

where

R1-R5 independently of one another, are H or a C1 C12-alkyl moiety,
R6 is a C1-C12-alkyl group,
x and y are from 0 to 100,
x + y is greater than 0, and
z is from 2 to 100,
where these data relate to the average of the polymers used in the chain extender.

**10.** Film according to Claim 9, **characterized in that** the amount of the chain extender present in the film is less than 2 % by weight and at least 0.05 % by weight.

**11.** Process for producing a film according to Claim 1, where the melts corresponding to the individual layers of the film are extruded through a flat-film die, the resultant film is drawn off and quenched on one or more rolls (chill roll) for solidification in the form of a substantially amorphous prefilm, the film is then reheated and biaxially stretched (oriented), and the biaxially stretched film is heat-set and then wound up, and where the film comprises at least one copper salt and one halide.

**12.** Use of a film according to Claim 1 for electrical insulation applications.

**13.** Laminate, comprising at least one film according to Claim 1 and at least one further film.

**14.** Solar module, comprising a film according to Claim 1.

**Revendications**

**1.** Film étiré de manière biaxiale, dont les constituants polymères sont constitués majoritairement d'un polyester, dans lequel le film contient au moins un sel de cuivre et un halogénure, dans lequel le rapport molaire entre l'halogénure et le Cu présente une valeur de 0,5 à 3,5 et le film présente une résistance à la tension (résistance à la perforation) CA (courant alternatif) d'au moins 100 kV/mm à une température de 23 °C et à 50 Hz, dans lequel la mesure de la résistance à la tension est effectuée selon la norme DIN 53481-3 en tenant compte de la norme DIN 40634 pour les instructions spécifiques de film et l'humidité de l'air relative dans l'air étant mesurée au moyen d'une bille/plaque (diamètre d'électrode 49,5 mm) en présence d'une tension alternative sinusoïdale de 50 Hz à une température de 23 °C et de 50 °C.

**2.** Film selon la revendication 1, **caractérisé en ce que** le sel de cuivre est un sel du Cu(II).

**3.** Film selon la revendication 1 ou 2, **caractérisé en ce que** le contre-ion du cuivre dans le sel de cuivre est un anion mono- ou polyvalent d'un acide carboxylique, d'un amide ou d'un analogue acétylé d'un acide carboxylique.

**4.** Film selon l'une quelconque des revendications 1 à 3, **caractérisé en ce que** l'halogénure est choisi parmi l'iodure, le chlorure et le bromure et est de préférence un halogénure alcalin.

**5.** Film selon l'une quelconque des revendications 1 à 4, **caractérisé en ce que** le film contient 15 à 600 ppm d'halogénure (par rapport à la masse du film).

**6.** Film selon l'une quelconque des revendications 1 à 5, **caractérisé en ce qu'**est présent, outre l'halogénure, un autre agent de réduction différent de l'halogénure.

**7.** Film selon la revendication 6, **caractérisé en ce que** l'agent de réduction différent de l'halogénure est présent dans le rapport molaire entre le cuivre(II) et l'agent de réduction supplémentaire allant de 0,5 à 2,5.

**8.** Film selon l'une quelconque des revendications 1 à 7, **caractérisé en ce que** le film contient en tant que stabilisateurs d'hydrolyse un dérivé d'acide gras époxydé.

**9.** Film selon l'une quelconque des revendications 1 à 8, **caractérisé en ce que** le film contient un ou plusieurs agents d'allongement de chaîne, et **en ce que** l'agent d'allongement de chaîne est un polymère, qui est décrit par la formule 1

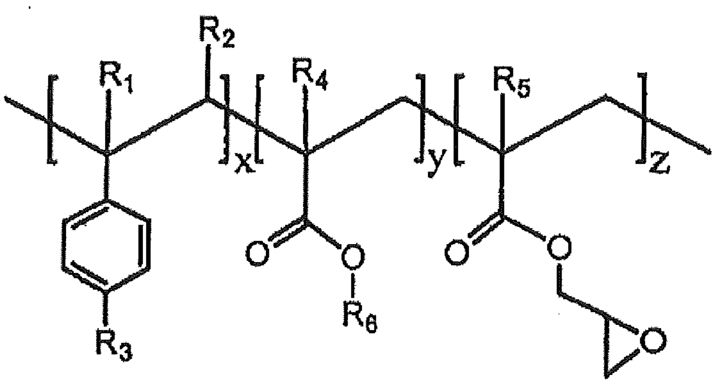

Formule 1

dans laquelle

$R_1$-$R_5$ sont, indépendamment les uns des autres, H ou un radical alkyle en $C_1$ à $C_{12}$,
$R_6$ est un groupe alkyle en $C_1$ à $C_{12}$,
x et y sont compris entre 0 et 100,
x + y est supérieur à 0 et
z est compris entre 2 et 100,
dans laquelle lesdites informations se rapportent à la moyenne des polymères utilisés de l'agent d'allongement de chaîne.

**10.** Film selon la revendication 9, **caractérisé en ce que** l'agent d'allongement de chaîne est contenu dans le film en une proportion inférieure à 2 % en poids et supérieure ou égale à 0,05 % en poids.

**11.** Procédé servant à fabriquer un film selon la revendication 1, dans lequel les matières fondues correspondent aux différentes couches du film étant extrudées par une buse plate, le film ainsi obtenu est retiré et trempé aux fins du renfort sur un ou plusieurs cylindres (cylindre de refroidissement) en tant que film précurseur largement amorphe, le film est immédiatement après à nouveau chauffé et étiré (orienté) de manière biaxiale et le film étiré de manière biaxiale est thermofixé et enroulé immédiatement après et dans lequel le film contient au moins un sel de cuivre et un halogénure.

**12.** Utilisation d'un film selon la revendication 1 pour des applications d'isolation électrique.

**13.** Stratifié, contenant au moins un film selon la revendication 1 et au moins un autre film.

**14.** Module solaire, contenant un film selon la revendication 1.

Figur 1

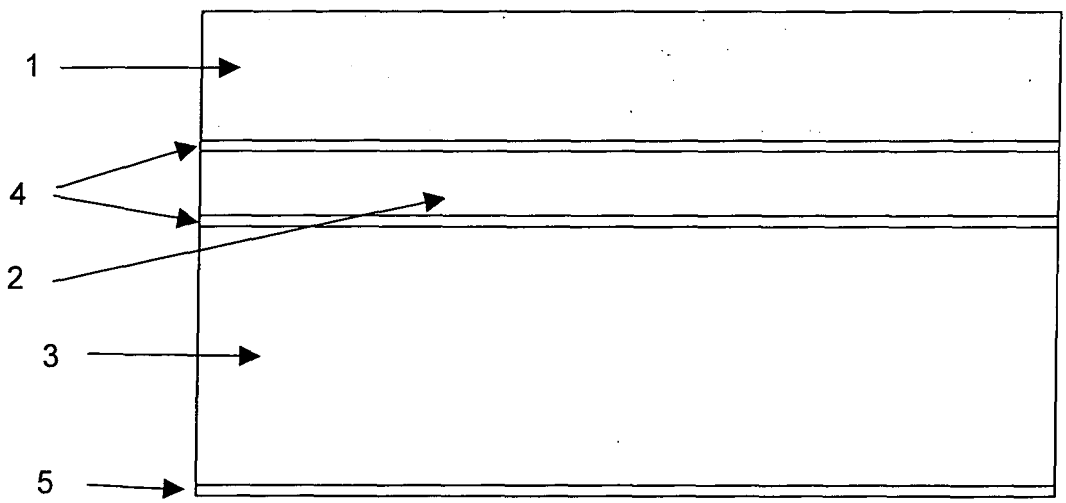

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 3051212 A
- DE 19526405 A
- US 2002065346 A
- EP 1499668 A
- US 3446766 A
- FR 2812299 A
- GB 1048068 A
- US 3432591 A
- EP 0738749 A


### In der Beschreibung aufgeführte Nicht-Patentliteratur


- **MCMAHON et al.** *Journal of Chemical Engineering Data,* Januar 1959, vol. 4 (1), 57-78
- **GÄCHTER MÜLLER.** Kunststoffadditive. Carl Hanser-Verlag
- **DR. HANS ZWEIFEL.** Plastics Additives Handbook. Carl Hanser-Verlag
- *CHEMICAL ABSTRACTS,* 6683-19-8
- *CHEMICAL ABSTRACTS,* 6046-93-1
- *CHEMICAL ABSTRACTS,* 7681-11-0
- *CHEMICAL ABSTRACTS,* 10039-56-2